# EUROPEAN PATENT APPLICATION

(11) **EP 3 226 649 A1**
(43) Date of publication of application: **04.10.2017**
(21) Application number: 17000408.9
(22) Date of filing: 14.03.2017
(51) Int. Cl.: H05B 1/02, A47G 9/02, H02H 11/00

(54) **IMPROVED THERMAL APPLIANCE WITH REDUCTION OF THE ELECTRIC FIELD EMISSION**

(30) Priority: 24.03.2016 IT UA20162008
(71) Applicant: Tenacta Group S.p.A., 24052 Azzano S. Paolo (BG) (IT)
(72) Inventor: Morgandi, Arturo, 24052 Azzano San Paolo (BG) (IT); Caccia, Giorgio, 24052 Azzano San Paolo (BG) (IT)
(74) Representative: Contessini, Pier Carlo

(57) **Abstract**

The present invention relates to a thermal appliance, which includes a blanket and a heating element distributed inside the blanket, and a power control unit which is electrically connectable on one side to the heating element and on the other side to a power outlet of the AC power supply network via a power plug.

The thermal appliance is characterized in that such a power control unit comprises at least a checking device adapted to detect the polarization direction with which said power plug has been inserted into said power outlet of the AC power supply.

In this way the thermal appliance of the invention is able to ensure in an economic and efficient way that the appliance itself generates an electric field lower than other connecting configurations to the network appliance.

## Description

### Field of the invention

The present invention relates to a thermal appliance such as a thermal blanket, a heating pad, a heating mat and similar heating appliances; in particular, the present invention relates to such a heating appliance provided with one or more electrical parts which have the purpose of allowing the user a more convenient use of the blanket with a reduction of the electric field emission.

### Background.

The thermal blankets, heating pads, heating mats and similar products have long been known, and generally include a power control unit and an operating unit electrically connected to it independently for each heated zone; these two units can be connected one each other in a permanent way or they can be separate and electrically connectable via an interconnection cable eventually provided with a connector. The operating unit generally comprises a blanket, for example, consisting of textile material, and a linear heating element distributed inside the blanket consisting of one or more conductors, mostly with a serpentine shape, having a path such as to favor, or rather, not hinder too much, the blanket bending. Furthermore, it is also known that each half side of the blankets suitable for a double bed is usefully treated with two separated operational units to allow each of the two occupants of the bed to independently manage its own operating unit

Normally, the heating element comprises a first and a second coaxial conductor, wherein the first conductor is disposed in a spiral around an electrically insulating core, generally textile, and wherein the second conductor is wound in a spiral around the first conductor, with an electrically insulating material interposed therein; the whole being further enclosed by an outer coating made of electrically insulating material. The heat is electrically produced by Joule effect in the conductors, and from here it is distributed in the blanket.

It is also known from a regulation point of view that the Technical Committees dealing with the upgrading of the electrical appliances safety standards are requested to introduce changes in the appliance safety standards. Among these the IEC 62233 standard exists, dealing with the control of the magnetic fields emission limits, typically measured in µTesla. Furthermore, in order to reduce the emission of said magnetic fields, electrical circuits equivalent to that one shown in Figure 1 as a scheme of this patent are known in the art. However, in addition to the emission of magnetic fields, the emission issue of the electric field is further relevant, typically measured in Volt/m, which, even if it does not represent a safety problem for the user when he uses an appliance working with a mains voltage lower than 250V in the frequency limits of the home network, for example 50 or 60Hz, it can sometimes create an unpleasant nuisance moreover inspiring a certain fear for people who do not know the technical reason of that when they experience an electrostatic current type while using electric blankets. Such discomfort exponentially increases when a particular environmental condition occurs, such as for example an environment having a particularly low relative humidity value, e.g. only 50% or when the value of the generated electric field exceeds defined values such as for example 60 V/m.

The above-mentioned issue is amplified when two users simultaneously use a blanket for a double-size bed that contains two detached operating units and one of this unit is in the off position. In fact, it can happen that the left-hand user feels an electric shock (similar to an electrostatic current) when its operational unit is turned off and he/she touches the right-hand user in the bed that, on the contrary, is using its operating unit to heat his/her bed portion. This phenomenon gives rise to complaints and negative impact on the product quality image.

In fact, typically a thermal appliance is connected to the power supply outlet of alternating electric current via a cable that ends in a plug inserted in the outlet. The electrical current is typically distributed with two lines, respectively, "phase" and "neutral" lines, wherein the latter line shows a voltage or potential difference almost zero with respect to the ground, while the "phase" line has an alternating voltage whose value depends on the electricity distribution network, especially 230V in Europe and many other countries, 115V in USA, 100V in Japan, etc.

In some countries, such as England, Australia or the United States of America, the plug/outlet pair of the power supply network is polarized. Therefore, in such countries, it is possible to adopt the production proper devices to ensure that the conductors of the phase and neutral lines, respectively, are connected in such a way that the electric field heat generated by the thermal appliance is minimized, below the perceptible threshold levels perceptible by the user, thus eliminating any kind of inconvenience to the user.

On the contrary, in some other countries, such as for example in many European countries or in Korea, the plug/outlet pair of the power supply network, in particular the plug model certified for a maximum current of 2.5 A, is not polarized, and thus the conductors of the phase and neutral lines, respectively, will be randomly connected to the plug terminals, and consequently to the control circuit and to the thermal appliance.

As a consequence of such a randomly connection, the electric field generated by the thermal appliance will depend on the direction of insertion of the plug into the outlet, that is it will be greater in a connecting direction of the plug and lower when the plug is connected in the opposite connecting direction.

Therefore, when the product is powered by a not polarized power plug, there is no possibility to obtain the same benefit which is obtained with the use of a polarized power plug, unless known in the art are sophisticated, very complex and expensive systems are used, involving the use of electrically conductive networks, distributed on the whole blanket and functionally connected to ground through a specific conductor, able to drastically reduce or reset the electric and magnetic field emission.

For example, U.S. patent published with No. US 5,173,587 describes an electrical heating device, such as an electric blanket, connected to a checking device able to determine the polarization direction with which the power plug has been inserted into the outlet of the alternating electric power. Such a checking device is a very complex system, consisting of a considerable high number of elements and therefore it results to be expensive, difficult to be realized and subjected to malfunction. The cited patent discloses how to maintain a negative electrical potential on the thermal blanket regardless how the power plug is inserted into the outlet. However, the thermal blanket therein described works with one polarity only, in particular the negative polarity.

To overcome this randomness of the phenomenon, it is necessary to provide the user with the information, in a simple and economical way, if the connecting direction of the appliance is the one generating the least electric field.

Therefore, the Applicant of the present patent application has noticed the need to provide the user with such an information relating to the correct insertion of the plug into the outlet to generate the least electric field.

### Summary of the invention

In a first aspect, the present invention relates to a thermal appliance as indicated in claim 1.

The Applicant of the present application has in fact surprisingly found that a thermal appliance, comprising a blanket and at least one heating element distributed inside the blanket, and a power control unit which is electrically connectable on one side to said heating element and on the other side to a power outlet of the AC power supply network via a power plug, and wherein said heating element contained inside the blanket is fed with both the positive and negative phases of the AC power supply, wherein said thermal appliance is characterized in that said power control unit comprises at least a checking device adapted to detect the polarization direction with which said power plug has been inserted into said power outlet of the AC power supply,
is able to minimize the generated electric field, ensuring economically and efficient security for any user of the thermal appliance.

In fact, in view of the fact that the thermal appliance of the present invention works with double polarity, positive and negative, and thanks to the usage of such a device able to determine the insertion direction of the power plug into the power outlet, it is possible to set said power control unit so that a minimum electric field is generated by the thermal appliance, suitably connecting the phase and neutral lines, thus reducing the feeling of electric shock described above noted by the user in the known in the art thermal appliances.

In order to achieve such an electric field reduction effect it is important that the thermal blanket is directly fed.

As a result, the user is informed if the direction of insertion of the power plug in the outlet is correct, that means on which wire is running the phase line and on which wire is running the neutral line; in case such a direction of insertion is not correct, the user will insert the plug in the opposite direction.

By the term "thermal appliance" in this text and in the appended claims is intended an appliance mainly, but not exclusively, intended to heat a bed or a person in bed, such as a thermal blanket, a heating pad, a heating mat or a similar thermal appliance having a substantially flat shape and of any size, that is adapted to completely cover a bed or only a portion of it or a portion of the body or a portion of the floor.

Preferably, said thermal appliance is a thermal blanket.

Preferably, said blanket is connected via a first cable portion to the power control unit, which in turn is connected, via a second cable portion, to said power plug.

Preferably, said electric current is distributed from said power outlet to said thermal appliance via a first AC power supply line (A), also said "phase" line, which presents an alternating voltage value depending on the electrical distribution network, and via a second AC power supply line (B), also said "neutral" line, which presents a voltage or potential difference almost equal to zero with respect to ground.

In this way, when the "phase" A line is connected to the heating element distributed inside the blanket, even directly or through a low impedance circuit, the electric field generated by the thermal appliance will be relatively higher compared to the condition wherein instead is the "neutral" line to be connected to the same heating element, either directly or through a low impedance circuit.

Accordingly, the best condition will be obtained when the neutral line is connected to the heating element, even directly or through a low impedance circuit.

Preferably, said thermal device is supplied with an AC voltage lower than 250V and with a frequency of for example 50Hz or 60Hz.

In this way, although the frequency of the voltage is an important parameter to determine the electric field generated by such a voltage, as long as the mains voltage frequency is 50Hz or 60Hz, that is the voltage frequency available in almost all the countries, it will not influence the present invention, which therefore finds its application for all of the practical use network frequencies.

Preferably, said power control unit further comprises a power controller controlling the power supplied to a heating resistor inserted into the blanket.

Preferably, said power control unit further comprises a bipolar type main switch able to connect/disconnect both said first and second AC supply lines (A) and (B) to/from said power controller.

Preferably, said main switch is made of electro-mechanical, electronic or electro-mechanical-electronic mixed technology.

In this way, the internal wiring of the unit control module are fixed, and thus the connecting direction of the heating resistor with respect to the supply from the mains in alternating current to the terminals of the supply lines A and B is equally fixed, and it depends only on the direction in which the user inserts the power plug into the wall outlet.

Preferably, said checking device is an electrical circuit. More preferably, said electric circuit is connected, on one side, via a first terminal, to a branch that connects said power controller to said heating resistor of said blanket and, on the other side, via a second terminal, to said first AC supply line (A). Preferably, said circuit is also connected to said second AC supply line (B) through a third terminal.

In this way, said first terminal, connected to the thermal appliance, for very small currents behaves as a ground connection as a consequence of the current dispersed towards the ground by the thermal appliance.

Preferably, said checking device is connected to a warning system providing an indication of the luminous, sound or graphic type, about the configuration status of the blanket connection to the electric network.

Preferably, said warning system is constituted by or is connected to a neon light or to a LED, capable of emitting a light signal.

In a first embodiment such a circuit it is constituted by a neon lamp. In this case, if said third terminal is connected to the supply "phase" line of the AC network, said third terminal itself is subject to a voltage with respect to ground of 230 VAC, for a typical supply network in use in Europe. However, the same concept is also applied to AC networks of lower voltage, such as 115VAC in the USA or 100VAC in Japan.

In this way, when both poles of said main switch are open, at the terminals of the neon lamp there will be a potential difference, namely a voltage, sufficient to generate a current which, although small, is sufficient to turn on the neon lamp, and thus to indicate that the third terminal is "on".

Conversely, if the third terminal is connected to the power "neutral" line of the AC network, such third terminal is subjected to a voltage almost zero with respect to ground. Consequently, when both poles of said main switch are open, the voltage at the terminals of the lamp will not be sufficient to generate any current, and thus the neon lamp will remain off, thereby indicating that the third terminal is not "on".

In a second embodiment, this circuit is constituted by an LED, connected in series with a resistance.

As described above, when both the poles of said main switch are opened, if the third terminal is connected to the "phase" line of the AC network, a potential difference at the terminals of the circuit, constituted by the LED and by the resistance connected in series, will be established in this embodiment, too. This voltage will then allow a current to run through the LED, limited by the resistor; this current will turn on the LED and thus will provide an indication that the third terminal is "on". Conversely, if the third terminal is connected to the "neutral" line of the AC network, there will be no difference in potential in the circuit, and thus no current will flow, and the LED will remain off, thereby indicating that such a third terminal is not "on".

Preferably, said LED is possibly connected to a diode.

In this way, the diode is necessary to prevent that a reverse voltage on the LED is as such to damage the LED itself, and is therefore optional if the LED is of the type resistant to the reverse voltage applied without any damage.

Therefore, by using said circuit is then possible to act in a way that the heating resistance of the thermal appliance is preferably connected to the supply "neutral" line of the AC network (lamp "off"). In this way, the electric field generated by the blanket will be significantly lower than the one generated by the same thermal appliance when the heating resistor is connected to the supply "phase" line of the AC network.

Preferably, said thermal appliance further comprises a polarity exchanger, inserted between said main switch and said power controller; preferably, said polarity exchanger is also connected to said checking device.

In such a way it is possible to establish the connection to the network in order to always generate the least electric field onto the blanket, whichever the situation is.

In a second aspect, the present invention relates to a method as indicated in claim 9.

The Applicant of the present application has in fact surprisingly found that a method for determining the connecting status to the electric network of a thermal appliance as the one described above is optimal or if it can be optimized, the method comprising the steps of:
a) quantitatively detecting the current passage by means of said checking device;
b) transmitting to the power control unit the information relating to the amount of current thus detected;
c) checking whether this detected current amount is such as to ensure the generation of a minimum electric field;
d) upon this check, alerting the user of possibly reverse the direction of insertion of said power plug into said power outlet of the AC power supply,
is able to minimize the electric field generated, ensuring economic, efficient and effective security for any user of the thermal appliance.

In fact, according to what detected by such a checking device, the user can be informed if the power plug has been inserted or not in the correct way, and eventually reverse this sense of insertion of the power plug in the outlet, so as to minimize the generated electric field.

Preferably, said method also comprises the step of exchanging the polarity to ensure that the network connection is always such as to generate the least electric field.

In this way, the system may automatically recognize which is the best possible connection between the terminals of the supply lines A and B and consequently operate the polarity exchanger, in such a way to always establish a connection to the network in order to generate the least electric field on the thermal appliance.

Further characteristics and advantages of the present invention will become more apparent from an examination of the following detailed description of a preferred embodiment, but not exclusive, illustrated only by way of non-limiting example, with the support of the attached drawings, in which:
- Figure 1 is a schematic view of an embodiment of a thermal appliance according to the present invention connected to a power outlet of the electric current supply;
- Figure 2 shows in detail a first embodiment of the power control unit of the thermal appliance shown in Figure 1;
- Figure 2A shows an exploded view of the control block 102 of Figure 2, wherein the switching element 140 is highlighted in 3 different embodiments:
- Figure 2B shows an embodiment wherein a phase/neutral connection type to the AC network is shown;
- Figure 2C shows another embodiment wherein the phase/neutral connection to the AC network is opposite compared to that one of Figure 2B;
- Figure 3 shows in detail a first embodiment of a checking device included in the power control unit of the thermal appliance shown in Figure 2;
- Figure 4 shows in detail a second embodiment of a checking device included in the power control unit of the thermal appliance shown in Figure 2;
- Figure 5 shows in detail a second embodiment of the power control unit of the thermal appliance shown in Figure 1, wherein a polarity exchanger is visible;
- Figure 6 shows in detail the blocks forming the checking device contained inside the power control unit of the thermal appliance shown in Figure 5, or the one of Figure 2 when the terminal 114 is unconnected.

### Detailed description

The following detailed description relates to a particular embodiment of the thermal appliance of the present invention, without limiting its content.

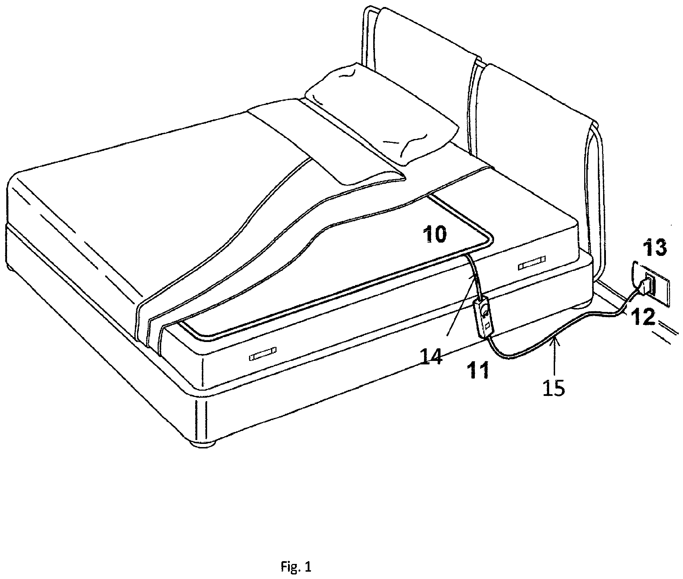

Referring to Figure 1 a thermal blanket laid on a double bed 10 is described and connected via a first cable portion 14 to the control circuit 11, which in turn is connected, via a second cable portion 15, to the plug 12 that is inserted into the power outlet 13 of the alternating electric current power supply, having a double polarity, positive and negative. The thermal blanket 10 is fed with an alternating voltage having, for example, frequency of 50 or 60 Hz.

In the outlet 13, the electric current is distributed with two power supply lines, respectively, "phase" A line and "neutral" B line, where the latter presents a voltage or potential difference almost zero with respect to the ground, while the "phase" A line presents an AC voltage value depending from the electricity distribution network, being in particular 230V in Europe and in many other countries, 115V in USA, 100V in Japan, etc.

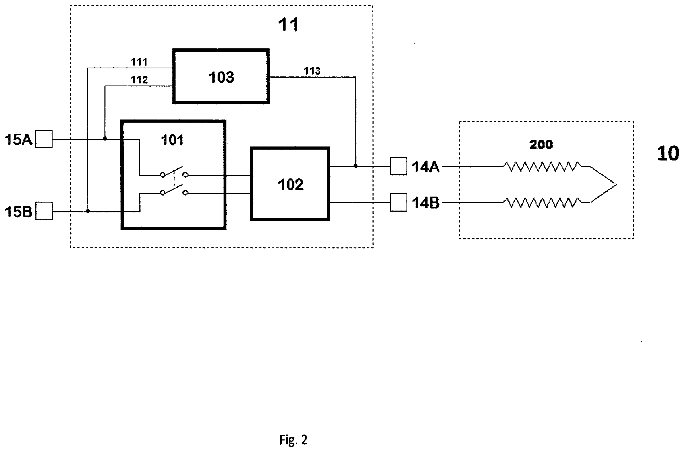

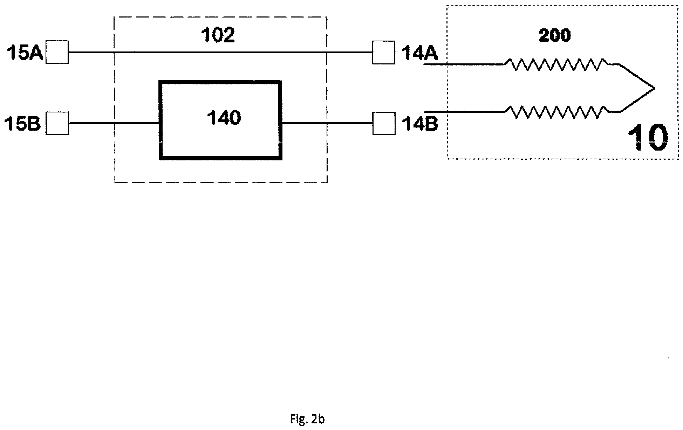

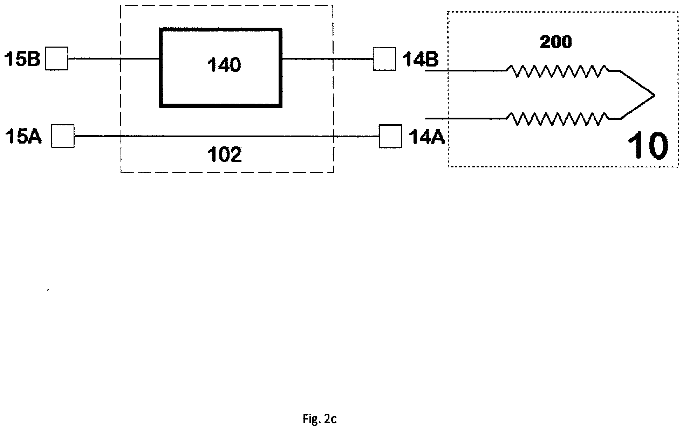

In particular it has been found that, as shown in Figure 2, showing an enlarged view of the control circuit 11 of Figure 1, when the phase A line is connected to the heating wire 200 of the electric resistor contained within the textile layer of the thermal blanket 10, even directly or through a low impedance circuit, the electric field generated by the blanket 10 will be relatively greater compared to the condition wherein the neutral B line is connected to the same heating wire 200, even directly or through a low impedance circuit.

Again with reference to Figure 2, the power supply control unit 11 further comprises a power controller 102 controlling the power delivered to the heating element 200 inserted inside the blanket 10 and a bipolar type main switch 101, able to connect/disconnect both the first and second alternating current supply lines, respectively, 15A and 15B to/from such a power controller 102. Furthermore, the power supply control unit 11 includes a checking device 103 able to detect the polarization direction with which said power supply plug 12 has been inserted into said power outlet of the alternating electric current power 13. The checking device 103 is connected, on one side, via a first terminal 113, to a branch that connects, via the cable portion 14A, the power controller 102 to the heating resistor 200 of the blanket 10 and, on the other side, via a second terminal 112, to the first alternating current power supply line 15A and, via a third terminal 111, to the second alternating current power supply line 15B.

In Figure 2A there is shown a detail of the power controller 102 of Figure 2, consisting of the current interruption block 140 and the block 145 which represents the block who manages the current interruption block 140.

The current interruption block 140 can be realized with an electrical contact, as indicated by the block 140A, or electronically, by means of a device of the SCR type, indicated by block 140B, or by means of a device of the TRIAC type, indicated by block 140C. Each of these blocks 140A, 140B and 140C allows to realize a single-pole interruption in the electric blanket.

Figure 2B shows the case wherein the current interruption block 140 seen in Figure 2A is connected to the phase line, while in Figure 2C such a current interruption block 140 is connected to the neutral line. The thermal blanket 10 can generate an emission of its electric field at the moment in which it is connected, on one side, to the phase line and, on the other side, the connection to the neutral line is interrupted. This can be a problem, therefore it is necessary that, when the blanket is turned off in a mono-polar way, the connection to the phase line is the one to be interrupted. Not being able to know which is the connection that has been interrupted at the shut down by the block 140 of the thermal blanket, the present invention allows the doubt to be resolved thanks to the presence of the checking device 103.

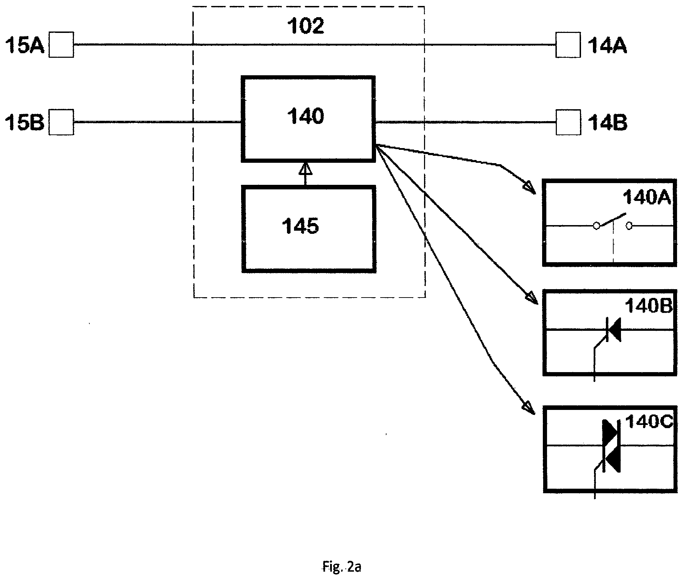

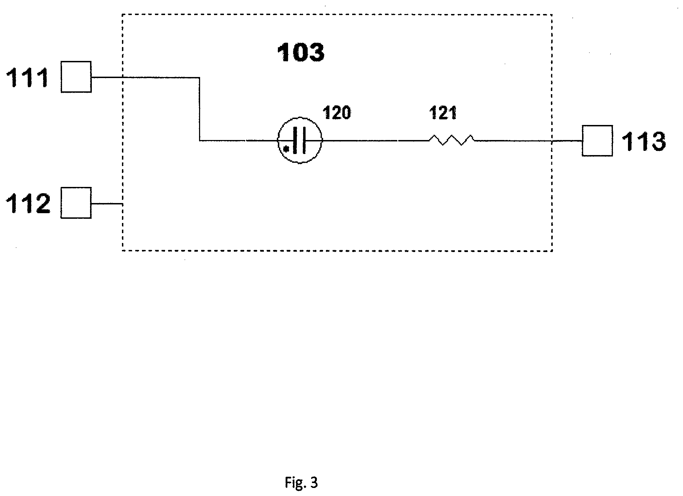

As shown in detail in Figure 3, the checking device 103 is an electric circuit connected to a warning system, constituted by a neon lamp 120, connected in series with a resistor 121. In this case, if the third terminal 111 is connected to the "phase" line power of the AC network, the third terminal 111 itself is subject to a voltage with respect to ground of 230 VAC, for a typical power supply network in use in Europe. However, the same concept is also applicable to lower voltage AC networks, such as 115VAC in U.S.A. or 100VAC in Japan.

In this way, when both the terminals of the main switch 101 are open, there will be a potential difference, namely a voltage, at the terminals of the neon lamp 120 sufficient to generate a current which, although small, is sufficient to turn on such a neon lamp 120, and thus to indicate that the third terminal 111 is "on"

Conversely, if the third terminal 111 is connected to the "neutral" line of the AC network, such a third terminal 111 is subject to a almost zero voltage with respect to ground. Consequently, when both the terminals of the main switch 101 are open, the voltage at the terminals of the neon lamp heads 120 will not be sufficient to generate any current, and thus the neon lamp 120 will remain off, thereby indicating that the third terminal 111 is not "on".

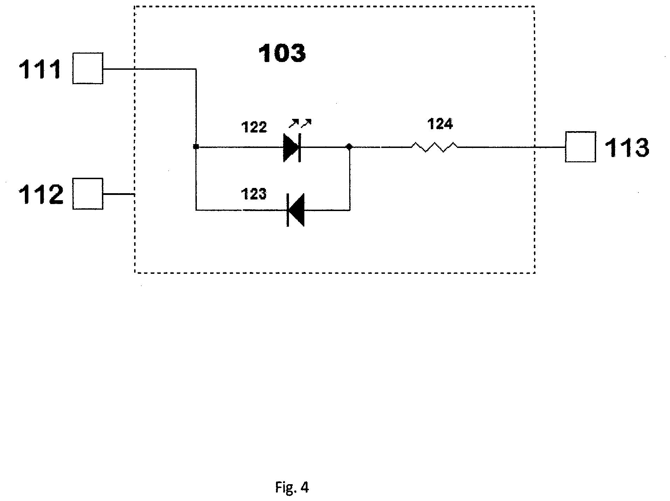

With reference to Figure 4, there is shown another embodiment of the checking device 103, constituted by a LED 122, connected in series to a resistance device 124. Also in this case, when both the terminals of the main switch 101 are open, analogously to what described above with reference to the neon lamp 120 shown in Figure 3, if the third terminal 111 is connected to the "phase" A line of the AC network, a potential difference at the terminals of the circuit 103, constituted by the LED 122 and the resistor 124 connected in series, will be established in this embodiment, too. This voltage will then allow a current to run through the LED 122, limited by the resistor 124; this current will turn on the LED 122 and thus will provide an indication that the third terminal 111 is "on". Conversely, if the third terminal 111 is connected to the "neutral" B line of the AC network, there will be no difference in potential in the circuit, and thus no current will flow, and the LED 122 will remain off, thereby indicating that such a third terminal 111 is not "on".

Conversely, if the third terminal 111 is connected to the "neutral" B line of the AC network, there will be no difference in potential in the circuit, and therefore no current will flow, and the LED 122 will remain off, thereby indicating that such third terminal 111 is not "on" The LED 122 is connected to a diode 123 which allows to prevent the reverse voltage on the LED 122 is as such to damage the LED 122 itself, and it is therefore optional if the LED 122 is of the type resistant to the applied reverse voltage without any damage.

Therefore, by using the circuit 103 is then possible to act in a way that the heating resistance 200 of the thermal appliance 10 is preferably connected to the supply "neutral" B line of the AC network (lamp 120 or LED 122 "off"). In this way, the electric field generated by the blanket 10 will be significantly lower than that the one generated by the same thermal appliance when the heating resistor 200 is connected to the supply "phase" A line of the AC network.

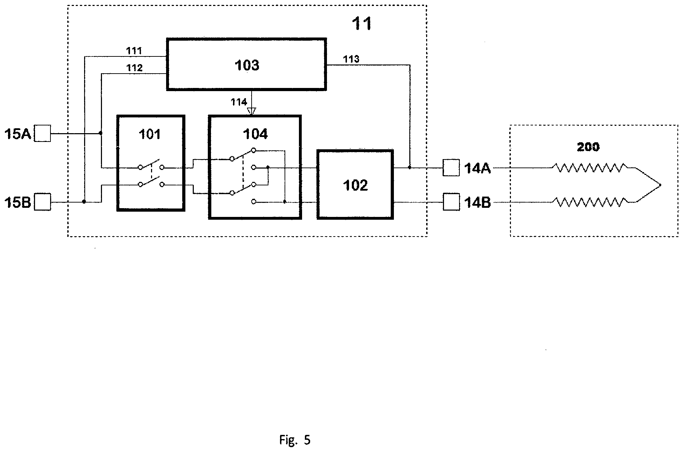

With reference to Figure 5, another embodiment of the control circuit 11 is shown, which further comprises a polarity exchanger 104, inserted between the main switch 101 and the power controller 102; furthermore, the polarity exchanger 104 is also connected to the checking device 103, so as to establish the connection to the network in such a way as to generate the least electric field on the blanket 10.

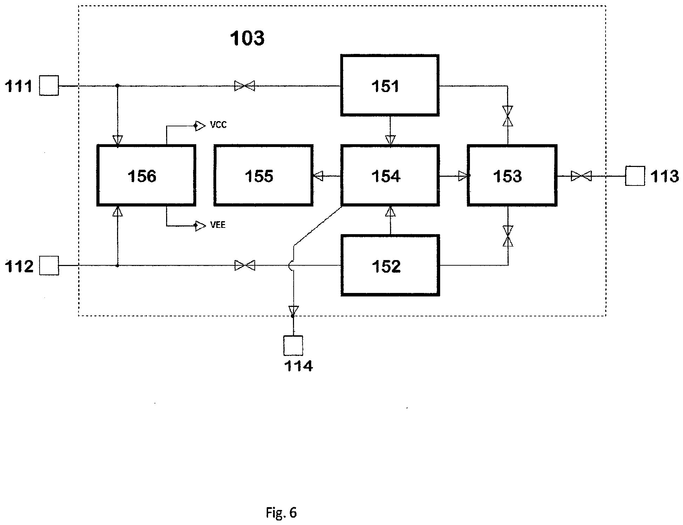

In Figure 6 the checking device 103 of the power control unit 11 of the thermal appliance shown in Figure 5 is shown in detail; in particular, the checking device 103 comprises a first current detection block 151, which measures the current flowing between the terminals 111 and 113 and a second current detection block 152, which measures the current flowing between the terminals 112 and 113. Furthermore, a connection selector 153, controlled by the control system 154, suitably connects the current detection circuit 151 or 152, or both, to the terminal 113. Finally, a display system 155 provides a preferably bright, but also possibly sound or graphic indication, about the control unit 11 connection configuration status to the power supply, or whether it is optimal or to be optimized.

The control system 154 may be a complex control circuit, realized through analog and/or digital technology, or simply a harness. Such a control system 154 is adapted to a): activate the selector 153 to connect the current detection circuit 151 and/or the current detection circuit 152 to the terminal 113; b) receive the information from the current detection circuit 151 and/or from the current detection circuit 152; c) develop the information and d) send it to the display system 155.

In Figure 6 the block 156 is also shown that is useful, if necessary, to provide the power supply voltage/s VCC and/or VEE to all or some of the electronic circuits internal to the checking device 103.

Of course, many modifications and variations of the preferred embodiments described will be evident to those skilled in the art, still remaining within the scope of the invention.

Accordingly, the present invention is not limited to the preferred embodiments described, illustrated only by way of example and not limitative, but is defined by the following claims.

## Claims

1. Thermal appliance (1) comprising a blanket (10) and a heating element (200) distributed inside the blanket (10), and a power control unit (11) which is electrically connectable on one side to said heating element (200) and on the other side to a power outlet (13) of the AC power supply network via a power plug (12), and wherein said heating element (200) contained in the blanket (10) is fed with both the positive and negative phases of the AC power supply, wherein said thermal appliance (1) is **characterized in that** said power control unit (11) comprises at least one checking device (103) adapted to detect the polarization direction with which said power plug (12) has been inserted into said power outlet (13) of the AC power supply.

2. Thermal appliance according to claim 1, wherein said blanket (10) is connected via a first cable portion (14) to the power control unit (11), which in turn is connected, via a second cable portion (15), to said power plug (12).

3. Thermal appliance according to claim 1 or 2, wherein the electric current is distributed from said power outlet (13) to said thermal appliance (1) via a first AC power supply line (A), also said "phase" line, which presents an alternating voltage value depending on the electrical distribution network, and via a second AC power supply line (B), also said "neutral" line, which presents a voltage or potential difference almost equal to zero with respect to ground.

4. Thermal appliance according to claim 3, wherein said power control unit (11) further comprises a power controller (102) controlling the power supplied to a heating resistor (200) inserted into the blanket (10) and a bipolar type main switch (101) able to connect/disconnect both of said first and second AC supply lines (A) and (B) to/from said power controller (102), wherein said checking device (103) is connected, on one side, via a first terminal (113), to a branch that connects said power controller (102) to said heating resistor (200) of said blanket (10) and, on the other side, via a second terminal (112), to said first AC supply line (A) and, via a third terminal (111), to said second AC supply line (B).

5. Thermal appliance according to any of the preceding claims, wherein said checking device (103) is an electrical circuit.

6. Thermal appliance according to any of the preceding claims, wherein said checking device (103) is connected to a warning system (155) providing an indication of the luminous, sound or graphic type, about the configuration status of the blanket (10) connection to the electric network.

7. Thermal appliance according to claim 6, wherein said warning system (155) is constituted by or is connected to a neon light (120) or to a LED (122), possibly connected to a diode (123) capable of preventing the damage of said LED (122).

8. Thermal appliance according to any of the preceding claims which further comprises a polarity exchanger (104), inserted between said main switch (101) and said power controller (102) and also connected to said checking device (103), in such a way to establish the network connection in order to generate the least electric field onto the blanket (10).

9. Method for the determining the connecting status to the electric network of a thermal appliance (1) including a blanket (10) and a heating element (100) distributed inside the blanket (10), and a power control unit (11) which is electrically connectable on one side to said heating element (200) and on the other to a power outlet (13) of the AC power supply network via a power plug (12), wherein said power control unit (11) comprises at least one checking device (103) adapted to detect the polarization direction with which said power plug (12) has been inserted into said power outlet (13) of the AC power supply, wherein the method comprises the steps of:
a) quantitatively detecting the current passage by means of said checking device (103);
b) transmitting to the power control unit (11) the information relating to the amount of current thus detected;
c) checking whether this detected current amount is such as to ensure the generation of a minimum electric field;
d) upon this check, alerting the user of possibly reverse the direction of insertion of said power plug (12) into said power outlet (13) of the AC power supply (13).

10. Method according to claim 9, which further comprises the step of exchanging the polarity (104) to ensure that the network connection is always such as to generate the least electric field.
